# EUROPEAN PATENT APPLICATION

(11) **EP 4 506 741 A1**
(43) Date of publication of application: **12.02.2025**
(21) Application number: 24181591.9
(22) Date of filing: 12.06.2024
(51) Int. Cl.: G02B 6/42

(54) **COOLED OPTICS ATTACHED TO A PRINTED CIRCUIT BOARD**

(30) Priority: 10.08.2023 US 202318447480
(71) Applicant: Nokia Solutions and Networks Oy, 02610 Espoo (FI)
(72) Inventor: BOLLE, Cristian, Bridgewater (US); EARNSHAW, Mark, Berkeley Heights (US)
(74) Representative: Nokia EPO representatives

(57) **Abstract**

An optical module includes a PCB having an electronic component mounted on a first side thereof. A heat sink is located along a second side of the PCB. A thermoelectric cooler (TEC) is disposed in an opening through the PCB and has a surface adjacent the heat sink. A laser is located at another surface of the TEC in a thermal contact therewith. An optical fiber mount is attached to the first side of the PCB to hold an optical fiber end in optical alignment with the laser.

## Description

### FIELD

Various example embodiments relate to electrical and optical modules with cooling.

### BACKGROUND

When fabricating optical transmitters and receivers, the electronics are typically assembled on a printed circuit board (PCB) while the optics are assembled inside a sealed package, typically a transistor outline (TO) can or a metal-ceramic box, which is then electrically connected to the printed circuit board. The electrical connection can be a flexible circuit or rigid electrical pins. A thermoelectric cooler (TEC) may be used to cool the optical components within the sealed package during operation.

### SUMMARY

An aspect of the present disclosure provides an apparatus comprising: a printed circuit board having an electronic component mounted on a first side thereof; a heat sink located along a second side of the printed circuit board; a thermoelectric cooler (TEC) disposed in an opening through the printed circuit board and having a surface adjacent the heat sink; a laser on another surface of the TEC; an optical fiber; and an optical fiber mount attached to the first side of the printed circuit board to hold an end of the optical fiber in optical alignment with the laser.

In some implementations, the apparatus further comprises a bulk optical collimating and/or focusing element mounted upon the another surface of the TEC between the laser and the optical fiber mount. In some implementations, the bulk optical collimating and/or focusing element is a lens.

In any of the above implementations, the apparatus may further comprise another bulk optical collimating and/or focusing element mounted to the printed circuit board in an optical path between the laser and the optical fiber mount. In some implementations, the another bulk optical collimating and/or focusing element is another lens.

In any of the above implementations, the apparatus may further comprise an optical isolator mounted to the printed circuit board between the laser and the optical fiber mount. In some implementations, the optical isolator may be between the lens and the another lens.

In any of the above implementations, the apparatus may further comprise an optical filter mounted to the printed circuit board between the laser and the optical fiber mount. In some implementations, the optical filter may be between the bulk optical elements lens.

In any of the above implementations, the another surface of the TEC may be substantially flush with the first surface of the printed circuit board.

In any of the above implementations, the heat sink may be in a mechanical contact with the second surface of the printed circuit board.

In any of the above implementations, the laser and the bulk optical element may be the only optical components mounted to the TEC.

In any of the above implementations, the electronic component may be a laser driver of the laser.

Any of the above implementations may further comprise a digital signal processor mounted to the printed circuit board.

Any of the above implementations may further comprise a cover over the laser and the bulk optical component(s) attached to the printed circuit board. In some implementations, the electronic component may be outside of the cover.

A second, related aspect of the present disclosure provides an apparatus comprising: a printed circuit board having an optical fiber mount attached to a first side thereof, a heat sink located along a second side of the printed circuit board, a TEC disposed in an opening through the printed circuit board and having a surface adjacent the heat sink, a laser on another surface of the TEC, wherein the optical fiber mount is to hold an optical fiber end in optical alignment with the laser, and a lens mounted upon the TEC between the laser and the optical fiber mount. In some implementations, the apparatus further comprises an electronic component mounted to the printed circuit board. The apparatus may further comprise an optical fiber having the optical fiber end. The electronic component may be, e.g., a laser driver.

Some implementation of the apparatus according to the second aspect may comprise a second lens mounted on the first side of the printed circuit board in an optical path from the laser to the optical fiber end.

In any of the above implementations according to the second aspect, the apparatus may further comprise a cover over the laser and the lens. The electrical component may be on the first side of the printed circuit board outside of the cover.

### BRIEF DESCRIPTION OF THE DRAWINGS

Embodiments disclosed herein will be described in greater detail with reference to the accompanying drawings which represent preferred embodiments thereof, in which like elements are indicated with like reference numerals, and wherein:
FIG. 1 is a schematic cross-sectional view of a first example of an optical module including optics on a PCB-embedded TEC;
FIG. 2 is a schematic cross-sectional view of a second example of an optical module including optics on a PCB-embedded TEC;
FIG. 3 is a schematic cross-sectional view of a third example of an optical module including optics on a PCB-embedded TEC;
FIG. 4 is a top view of an embodiment of the optical module of FIG 3 including a digital processor;
FIG. 5 is a schematic cross-sectional view of the optical module of FIG. 2 with the optics being locally encapsulated;
FIG. 6 is a schematic cross-sectional view of a fourth example of an optical module including PCB-mounted focusing or collimating optics for coupling to a laser on a PCB-embedded TEC.

### DESCRIPTION

In the following description, for purposes of explanation and not limitation, specific details are set forth, such as particular circuits, circuit components, techniques, etc. in order to provide a thorough understanding of the present invention. However, it will be apparent to one skilled in the art that the present invention may be practiced in other embodiments that depart from these specific details. In other instances, detailed descriptions of well-known methods, devices, and circuits may be omitted so as not to obscure the description of the present invention. All statements herein reciting principles, aspects, and embodiments of the invention, as well as specific examples thereof, are intended to encompass both structural and functional equivalents thereof. Additionally, it is intended that such equivalents include both currently known equivalents as well as equivalents developed in the future, i.e., any elements developed that perform the same function, regardless of structure.

Furthermore, the following abbreviations and acronyms may be used in the present document:
PCB: Printed Circuit Board
TO: Transistor Outline
TEC: Thermoelectric Cooler
EML: Electro-absorption Modulated Laser
FPGA: Field Programmable Gate Array
DAC: Digital to Analog Converter
ASIC: Application Specific Integrated Circuit

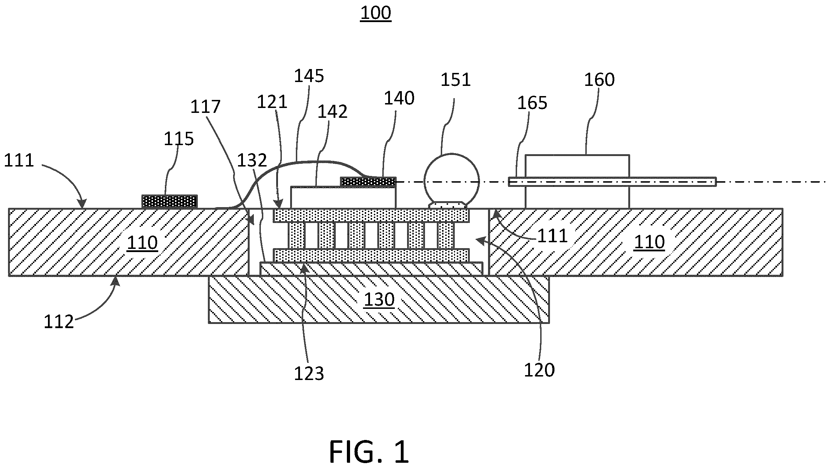

FIG. 1 illustrates an example apparatus 100 in a vertical cross-section. The apparatus 100 may include a part or all of an optical transceiver, e.g., in a small form-factor pluggable such as an SFP, QSFP, or the like. The apparatus 100 includes a printed circuit board 110, which may have an electronic component 115 mounted on a first side 111 thereof. A heat sink 130 is located largely along a second side 112 of the printed circuit board 110. A thermoelectric cooler (TEC) 120 is disposed in an opening 117 through the printed circuit board 110. The TEC 120 has a surface ("back surface") 123 adjacent to a surface of the heat sink 130, e.g., in direct mechanical contact therewith to provide high thermal conduction there between. A laser 140 is mechanically mounted upon another surface (e.g., a "top surface") 121 of the TEC 120 in good thermal contact therewith. In some embodiments, a highly thermally-conductive substrate 142 may be disposed between the laser 140 and the TEC 120 and in mechanical contact with nearby surfaces of both the laser 140 and the TEC 120. An optical fiber mount 160 is mechanically attached to the first side 111 of the printed circuit board 110 to hold an optical fiber end 165 in approximate optical alignment with the laser 140.

The laser 140 is electrically connected to the electronic component 115 with an electrical connection 145, which may be flexible or rigid. In an embodiment, the electronic component 115 is a laser driver configured to drive the laser 140 in operation. The laser 140 may be e.g., an electro-absorption modulated laser (EML), or another suitable semiconductor laser device.

Some embodiments may use, in place of the laser 140, another electrically-operated and/or electrically-energized optical device that in operation generates heat and/or is sensitive to temperature, such as an optical amplifier, e.g. a booster optical amplifier, or a photodetector, e.g. a photodiode, or an optical modulator.

In some embodiments, a lens 151, or another bulk optical focusing or collimating element as may be suitable in some configurations, may preferably be mounted on the top surface 121 of the TEC 120 between the laser 140 and the optical fiber mount 160, for coupling light emitted by the laser 140 into the optical fiber end 165. The lens 151 ("first lens") may be, e.g., a spherical lens or an aspheric lens. In a lens-less embodiment, the optical output of the laser 140 may be located very close to the near end of the optical fiber held by the optical fiber mount 160 to reduce optical coupling losses there between. In either of these embodiments, having the optical fiber mount 160, which fixes the alignment of the end 165 of the optical fiber, off the surface 121 of the TEC 120 enables the footprint of the TEC 120 to be smaller than in devices where the large footprint, optical fiber mount 160 is over or on the surface 121. The smaller surface 121 typically enables the TEC 120 to be operated at a lower power, for similar amounts of temperature cooling, than a TEC (not shown) on whose major surface both the laser 140 and an optical fiber mount are located.

In some embodiments, the top surface 121 of the TEC 120 may be substantially flush, e.g., with an accuracy within +\- 50 micron (µm) or better, with the first side 111 of the printed circuit board 110. In some embodiments, the heat sink 130 may have a mesa, as illustrated, or a cavity, upon or within which the TEC 120 may be mounted to level the top surface 121 of the TEC with the first side 111 of the printed circuit board 110. In some other embodiments, the top surface 121 of the TEC 120 may be vertically offset from the first side 111 of the PCB as may be convenient for optically aligning the laser 140 with the lens 151 and the optical fiber mount 160, i.e., the optical fiber end 165.

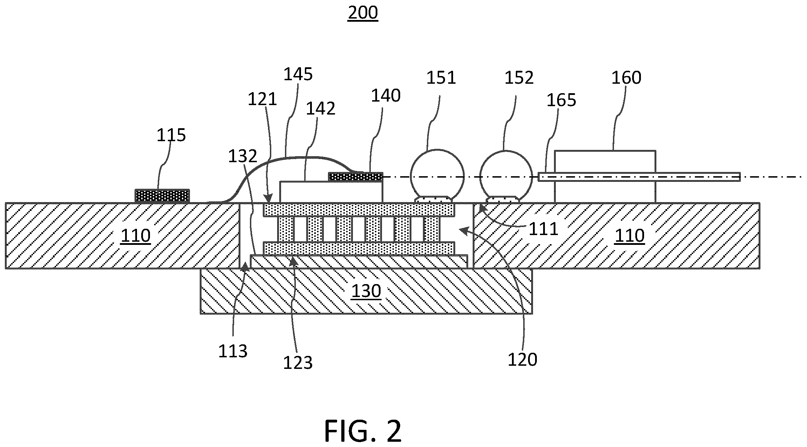

FIG. 2 illustrates an apparatus 200 in a vertical cross-section. The apparatus 200 is an embodiment of the apparatus 100 and includes many of the elements described above with reference to FIG. 1; these elements are indicated in FIGs. 1 and 2 with same reference numerals and may not be described here again. Compared to the apparatus 100, the apparatus 200 includes another lens 152 ("second lens") disposed between the (first) lens 151 and the optical fiber mount 160 in an optical path between the laser 140 and the optical fiber end 165. The second lens 152 is mechanically mounted to the printed circuit board 110 on the first side 111 thereof. The second lens 152 may assist in forming a lower loss optical coupling between the laser 140 and the optical fiber end 165, e.g., to make the laser-to-fiber optical coupling more tolerant to thermally-induced alignment variations between the optical fiber end 165 and the laser 140. The second lens 152 may be spheric or aspheric.

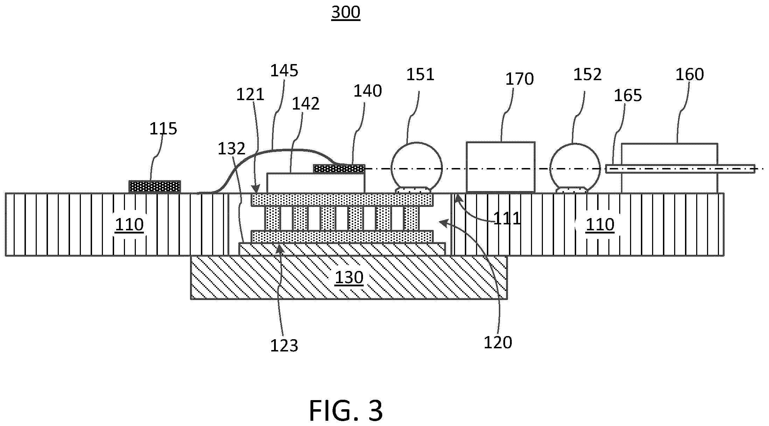

FIG. 3 illustrates an apparatus 300 in a vertical cross-section. The apparatus 300 is an embodiment of the apparatus 200 and includes many of the elements that are described above with reference to FIGs. 1 and 2; these elements are indicated in FIGs. 1, 2, and 3 with same reference numerals and are not described here again. Compared to the apparatus 200, the apparatus 300 includes another optical element 170 disposed between the (first) lens 151 and the optical fiber mount 160 in an optical path between the laser 140 and the optical fiber end 165. The optical element 170 is mounted to the printed circuit board 110 on the first side 111 thereof. In the illustrated embodiment, the optical element 170 is between the two lenses 151 and 152, but the optical element may alternatively, e.g., be locate between the lens 152 and the near end 165 of the optical fiber. In an example implementation, the optical element 170 is an optical isolator. The optical element 170 may also be, e.g., an optical filter, or some other optical element, or a combination of optical elements, which may be useful for a particular application of the apparatus 300.

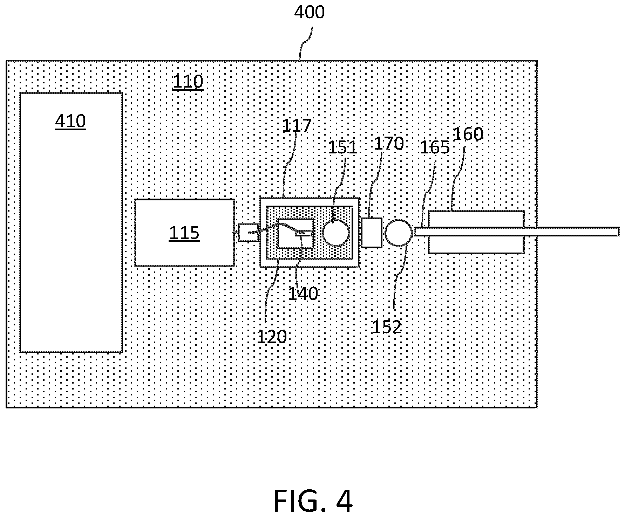

FIG. 4 illustrates a top view of the apparatus 300 of FIG. 3 according to an embodiment. In the illustrated example, the apparatus 300 includes a digital processor 410, e.g., an FPGA or an ASIC, optionally mounted upon the printed circuit board 110. The electronic component 115 is a laser driver electrically connected to the processor 410 and the laser 140 for driving the laser 140 with a signal generated according to the processor 410. In other embodiments, the processor 410 may be disposed outside of the printed circuit board 110. A digital to analog converter ("DAC", not shown) may be disposed in a signal path between the processor 410 and the laser driver 115. In some implementations the DAC may be disposed on the printed circuit board 110. In some embodiments, the processor 410 and the laser driver 115 may be implemented in a same integrated circuit, which may be mounted on the printed circuit board 110.

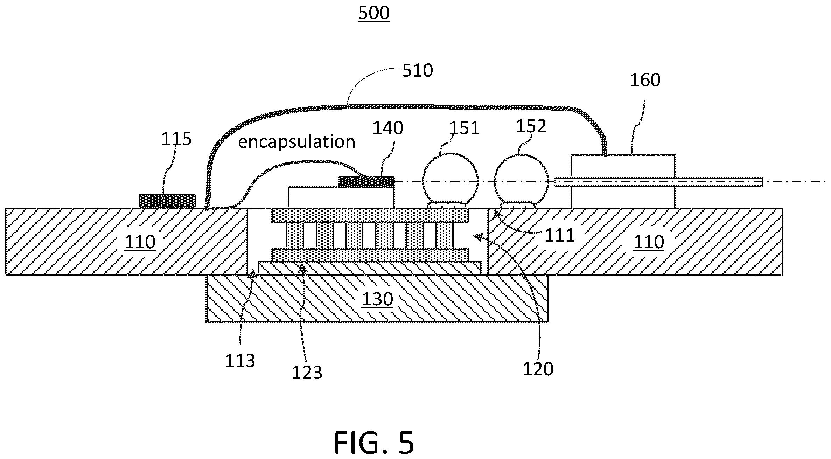

FIG. 5 illustrates an apparatus 500 in a vertical cross-section. The apparatus 500 is an embodiment of the apparatus 200 and includes many of the elements that are described above with reference to FIGs. 1 and 2; these elements are indicated in FIGs. 1, 2, and 4 with same reference numerals and are not described here again. The apparatus 500 includes a cover 510 locally encapsulating optical elements of the apparatus to protect them from dirt and humidity. In the illustrated example, the cover 510 is disposed over the laser 140 and the lenses 151, 152 and at least a part of the optical fiber mount 160. The cover 510 may be attached, e.g., glued or soldered, to the printed circuit board 110. In some embodiments, the cover 510 may be disposed over the optical elements 140, 151 attached to the TEC 120, with the second lens 151 being outside thereof.

In any of the apparatus described above, the laser 140 and, possibly, the lens 151 may be the only optical components mounted onto the TEC 120, allowing the TEC 120 to be suitably small and reducing the power consumption thereof. Positioning the TEC with the laser in an opening of a PCB, e.g., the printed circuit board 110, where the laser driver is located allows the electrical connection 145 between the driver and the laser to be short, which is beneficial at high modulation rates. Some embodiments may include one or more temperature sensors (not shown) in thermal contact with the top surface 121 of the TEC 120 as known in the art. The apparatus may further include a TEC driver (not shown) in communication with temperature sensor for controlling the TEC 120 to maintain the laser 140 at a desired temperature during operation.

In various embodiments, the PCB 110 typically provides substantial thermal isolation the heat generating electronics, e.g., the processor 410 and/or the laser driver 115 of FIG. 4, and the laser 140, which is laterally distant along the surface 111 of the PCB 110. For this reason, the smaller footprint TEC 120 may typically still be able to adequately control the temperature of the laser 140 even when strong heat generators are located at different lateral positions on the surface 111 of the PCB 110.

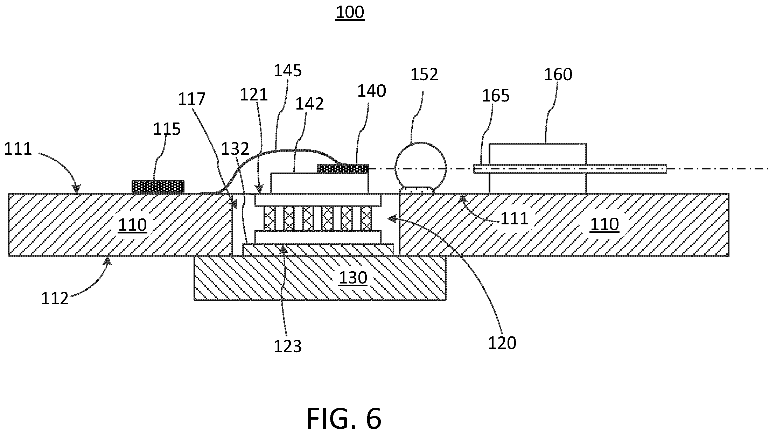

It will be understood by one skilled in the art that various changes in detail may be affected in the described embodiment without departing from the spirit and scope of the invention as defined by the claims. For example, any one of the apparatus 100 and the apparatus 300 may include a cover, such as the cover 510, locally encapsulating the optical components of the respective apparatus. The apparatus 100 and/or the apparatus 200 may include a digital processor 410, which may be mounted to the printed circuit board 110. In some embodiments of the apparatus 100, 200, 300, or 400 the lens 151 may be mounted to the printed circuit board 110, so that the laser 140 is the only optical component mounted to the TEC 120, e.g., as illustrated in FIG. 6; this would allow to reduce the size and the power consumption of the TEC, but may provide less stable optical coupling. Furthermore, in some embodiments, the lens 151, and/or the lens 152 where present, may be replaced with another bulk optical focusing and/or collimating element or device, including but not limited to a series of lenses.

Furthermore, in the description above, for purposes of explanation and not limitation, specific details are set forth such as particular architectures, interfaces, techniques, etc. in order to provide a thorough understanding of the present invention. In some instances, detailed descriptions of well-known devices, circuits, and methods are omitted so as not to obscure the description of the present invention with unnecessary detail. Thus, for example, it will be appreciated by those skilled in the art that block diagrams herein can represent conceptual views of illustrative circuitry embodying the principles of the technology. All statements herein reciting principles, aspects, and embodiments of the invention, as well as specific examples thereof, are intended to encompass both structural and functional equivalents thereof. Additionally, it is intended that such equivalents include both currently known equivalents as well as equivalents developed in the future, i.e., any elements developed that perform the same function, regardless of structure.

Thus, while the present invention has been particularly shown and described with reference to example embodiments as illustrated in the drawing, it will be understood by one skilled in the art that various changes in detail may be affected therein without departing from the spirit and scope of the invention as defined by the claims.

## Claims

1. An apparatus comprising:
a printed circuit board having an electronic component mounted on a first side thereof;
a heat sink located along a second side of the printed circuit board;
a thermoelectric cooler (TEC) disposed in an opening through the printed circuit board and having a surface adjacent the heat sink;
a laser on another surface of the TEC;
an optical fiber; and
an optical fiber mount attached to the first side of the printed circuit board to hold an end of the optical fiber in optical alignment with the laser.

2. The apparatus of claim 1, further comprising a bulk optical collimating and/or focusing element located along an optical path between the laser and the optical fiber mount.

3. The apparatus of claim 2, wherein the bulk optical collimating and/or focusing element is mounted upon the another surface of the TEC in an optical path between the laser and the optical fiber mount.

4. The apparatus of claim 3, further comprising another bulk optical collimating and/or focusing element mounted on the first side of the printed circuit board along the optical path between the laser and the optical fiber mount.

5. The apparatus of claim 2, wherein the bulk optical collimating and/or focusing element is mounted upon the first side of the printed circuit board.

6. The apparatus of claim 3, further comprising an optical isolator located on the first side of the printed circuit board along the optical path between the laser and the optical fiber mount.

7. The apparatus of claim 4, further comprising an optical isolator mounted to the printed circuit board on the optical path between the laser and the optical fiber mount between the bulk optical elements.

8. The apparatus of claim 3, comprising an optical filter mounted to the printed circuit board along the optical path between the laser and the optical fiber mount.

9. The apparatus of claim 1, wherein the another surface of the TEC is substantially flush with the first surface of the printed circuit board.

10. The apparatus of claim 3, wherein the bulk optical collimating and/or focusing element is a lens.

11. The apparatus of claim 3, wherein the laser and the bulk optical focusing and/or collimating element are the only optical components mounted on the TEC.

12. The apparatus of claim 1, wherein the electronic component includes a driver of the laser.

13. The apparatus of claim 4, comprising a cover over the laser and the bulk optical elements.

14. The apparatus of claim 13, wherein the electronic component is located along the first surface outside of the cover.
